# EUROPEAN PATENT SPECIFICATION

(11) **EP 1 358 670 B1**
(45) Date of publication and mention of the grant of the patent: **05.07.2006**
(21) Application number: 02736487.6
(22) Date of filing: 08.02.2002
(51) Int. Cl.: H01L 21/00, B08B 3/00, C11D 1/00, C11D 3/37, C11D 7/32, G03F 7/42

(54) **Process for removing residues from the microstructure of an object**
Prozess zum Entfernen von Resten aus der Mikrostruktur eines Objekts
Procédé destine à éliminer des residus de la microstructure d'un objet

(30) Priority: 09.02.2001 JP 2001034337
(43) Date of publication of application: 05.11.2003
(60) Divisional application: 04011792.1
(73) Proprietor: Kabushiki Kaisha Kobe Seiko Sho (Kobe Steel, Ltd.), Kobe-shi, Hyogo 651-2271 (JP)
(72) Inventor: MASUDA, Kaoru, Kobe Co. R. Lab. in Kobe Steel Ltd., Kobe-shi, Hyogo 651-2271 (JP); ILJIMA, Katsuyuki, Kobe Co. R. Lab. Kobe Steel Ltd, Kobe-shi, Hyogo 651-2271 (JP); SUZUKI, Tetsuo, Kobe Co. Rs. Lab in Kobe Steel Ltd, Kobe-shi, Hyogo 651-2271 (JP); KAWAKAMI, Nobuyuki, Kobe Co. R.Lab. Kobe Steel Ltd, Kobe-shi, Hyogo 651-2271 (JP); YAMAGATA, Masahiro, Takasago Works Kobe Steel Ltd., Hyogo 676-8670 (JP); PETERS, Daryl, W., Stewartsville, NJ 08886 (US); EGBE, Matthew, I., West Norriton, PA 19403 (US)
(74) Representative: Müller-Boré & Partner Patentanwälte
(86) International application number: PCT/US2002/003608
(87) International publication number: WO 2002/080233

(56) References cited:
- WO-A-01/33613
- WO-A-02/15251
- US-A- 5 709 756
- US-A- 6 024 801
- US-A1- 2002 048 731
- US-A1- 2002 086 537
- US-B1- 6 242 165
- US-B1- 6 277 753
- US-B1- 6 306 564
- US-B2- 6 331 487

## Description

The present invention relates to a process for removing residues from the microstructure of an object. The present invention specifically relates to a process for removing residues, such as resists, generated during a semiconductor manufacturing process from a semiconductor wafer surface having a fine structure of convex and concave portions.

It is required as one step in manufacturing a semiconductor wafer to remove residues, such as photoresists, UV-hardened resists, X-ray hardened resists, ashed resists, carbon-fluorine containing polymer, plasma etch residues, and organic or inorganic contaminants from the other steps of the manufacturing process. The dry and wet removal methods are commonly used. In the wet removal method, the semiconductor wafer is dipped in an agent, such as a water solution, including a remover to remove residues from the surface of semiconductor wafer. Recently, supercritical CO₂ is used as such an agent because of its low viscosity.

However, supercritical CO₂ is not enough by itself to remove several residues from the surface of the semiconductor wafer. To resolve this problem, several additives to supercritical CO₂ are proposed. As described in the Japanese unexamined patent publication No. 10-125644, methane or a surfactant having a CFx group is used as an additive to supercritical CO₂. In Japanese unexamined patent publication No. 8-191063, dimethylsulfoxide ordimethyl-formamide is used as such an additive. These additives are not always effective for removing residues.

Stripping processes are already known in the art, see for example WO 0133613, WO 0215251, US5709756 and US6331487.

An obj ect of the present invention is, therefore, to provide a process for effectively removing residues from the microstructure of an object.

According to the present invention, a process is provided for removing residues from the obj ect, which comprises steps of preparing a remover including a CO₂, an additive for removing the residues and a co-solvent for dissolving said additive in said CO₂at a pressurized fluid condition, and bringing the object into contact with said remover so as to remove the residues from the object.

A process is further provided for removing residues from the microstructure of an object, which comprises a step of contacting the object with a remover including a supercritical CO₂, a compound having hydroxyl group, and a fluoride of formula NR1R2R3R4F, where R represents a hydrogen or alkyl group.

The foregoing and additional features and characteristics of the present invention will become more apparent from the following detailed description considered with reference to the accompanying drawings in which like reference numerals designate like elements and wherein:
FIG. 1 is a schematic diagram of an apparatus for removing residues in accordance with the present invention.
FIG. 2 is a schematic diagram of another embodiment of the apparatus for removing residues in accordance with the present invention.
FIG. 3 shows an effect of the concentration of tetramethylammoniumfluoride (hereinafter referred to as "TMAF") on the etch rate.
FIG. 4 shows an effect of the concentration of ethanol on the etch rate.
FIG. 5 is a schematic diagram of a third embodiment of the apparatus for removing residues in accordance with the present invention.

The present invention is applied to the microstructure of an object, e.g., a semiconductor wafer having a fine structure of convex and concave portions on its surface, and a substrate made of a metal, plastic or ceramic which forms or remains continuous or noncontinuous layer of materials different therefrom. \

As the pressurized CO₂ is not enough by itself to remove residues, the pressurized CO₂ of the present invention, to which an additive and a co-solvent are added, is used as a remover for removing residues from the object. The additive used for this purpose can remove residues but cannot substantially dissolve in CO₂ by itself. The co-solvent used for this purpose can make the additive dissolved or dispersed homogeneously in CO₂.

The pressurized CO₂ has a high dispersion rate and enables the dissolved residues to disperse therein. If CO₂ is converted to a supercritical condition, it penetrates into fine pattern portions of the object more effectively. By this feature, the additive is conveyed into pores or concave portions on a surface of the object due to the low viscosity of CO₂, The CO₂ is pressurized to 5 MPa or more, but not less than 7.1 MPa at a temperature of 31°C to convert the CO₂ to a supercritical fluid condition.

The basic compound is used as the additive because it effectively hydrolyzes polymers typically used as a resist in manufacturing a semiconductor. The basic compound includes at least one element selected from the group consisting of quaternary ammoniumhydroxide and quaternary ammoniumfluoride. It is preferred to use a compound including at least one of quaternary ammoniumhydroxide and quaternary ammoniumfluoride, to remove novolac phenol resists from a semiconductor wafer. The quaternary ammoniumhydroxide may be any quaternary ammoniumhydroxide, e.g. tetramethylammoniumhydroxide, tetraethylammoniumhydroxide, tetrapropylammoniumhydroxide, tetrabutylammoniumhydroxide (hereinafter referred as TBAH), and choline. The quaternary ammoniumfluoride may be any quaternary ammoniumfluoride, e.g. tetramethylammoniumfluoride (hereinafter referred as TMAF), tetraethylammonium fluoride, tetrapropylammoniumfluoride, tetrabutylammoniumfluoride, and cholinefluoride.

The additive is preferably added in a ratio of not less than 0.001 wt. % of the remover, more preferably in a ratio of not less than 0.002 wt. %. When the additive is added in a ratio of more than 8 wt. %, the co-solvent should be added more, but the amount of CO₂ is decreased according to the amount of the added co-solvent, which decreases the penetration of CO₂ into a surface of the object. The upper range of the additive is 8 wt. %, preferably 6 wt. %, and more preferably 4 wt. %.

According to the present invention, the co-solvent is added to CO₂ together with the additive. The co-solvent of the present invention is a compound having an affinity to both CO₂ and the additive. Such a co-solvent dissolves or disperses the additive homogeneously in the pressurized CO₂ in fluid condition. An alcohol, dimethylsulfoxide or a mixture thereof is used as the co-solvent. The alcohol may be any alcohol, e.g. ethanol, methanol, n-propanol, iso-propanol, n-butanol, iso-butanol, diethyleneglycolmonomethyleter, diethyleneglycolmonoethyleter, and hexafluoro isopropanol, preferably ethanol and methanol.

The kind and amount of the co-solvent are selected depending on the kind and amount of the additive to CO₂, The amount of the co-solvent is preferably five times or more than that of the additive because the remover easily becomes homogeneous and transparent. Alternatively, the remover may include the co-solvent in a range of 1 wt. % to 50 wt. %. If more than 50 wt. % of the co-solvent is added, the penetration rate of the remover decreases due to less amount of CO₂. It is preferable to use a remover including CO₂, alcohol as the co-solvent, quaternary ammoniumfluoride and/or quaternary ammoniumhydroxide as the additive because these additives are well dissolved in CO₂ by alcohol and are CO₂-philic.

According to the present invention, it is preferable to contact the object with a remover composed of CO₂, a fluoride of formula NR1R2R3R4F, (R represents a hydrogen or alkyl group), and a compound having hydroxyl group, while CO₂ is high pressurized or is preferably kept at a supercritical condition. This remover is more effective to remove ashed residues from the semiconductor wafer. The fluoride may be any fluoride of formula NR1R2R3R4F where R represents a hydrogen or alkyl group, e.g. ammonium fluoride, tetramethylammoniumfluoride, and tetraethylammoniumfluoride. It is preferable to use the fluoride with Rs being alkyl groups, such as tetramethylammoniumfluoride andtetraethylammoniumfluoride because such fluorides are CO₂-philic. In the present invention, the remover may include the fluoride preferably in the range from 0.001 wt % to 5 wt % of the remover, more preferably in the range from 0.002 wt % to 0.02 wt % of the remover.

The fluoride is used as the additive to supercritical CO₂ in the presence of a compound having a hydroxyl group, e.g., alcohol (such as ethanol, methanol, n-propanol, isopropanol, n-butanol and isobutanol , phenol), glycol (such as ethylenglycol and methylenglycol and polyethylenglycol). The alcohol is preferred because it effectively dissolves or disperses the fluoride, such as TMAF, homogeneously in supercritical CO₂. Among alcohol, ethanol is preferable because a larger amount of the fluoride, such as TMAF, can be dissolved in supercritical CO₂ by the presence of the ethanol. The concentration of the compound in supercritical CO₂ depends on the kind and concentration of the fluoride, and the kind of the residue. Approximately, the compound is preferably included in supercritical CO₂ in the range from 1 wt % to 20 wt % of the remover.

It is preferable that the supercritical CO₂ further comprises dimethylacetamide (hereinafter referred to as "DMAC"). The DMAC contained in the CO₂ is preferably six to seventy times of the fluoride contained in the CO₂ by weight. Further, it is preferable that the supercritical CO₂ includes substantially no water, which is a hindrance for manufacturing semiconductor wafers.

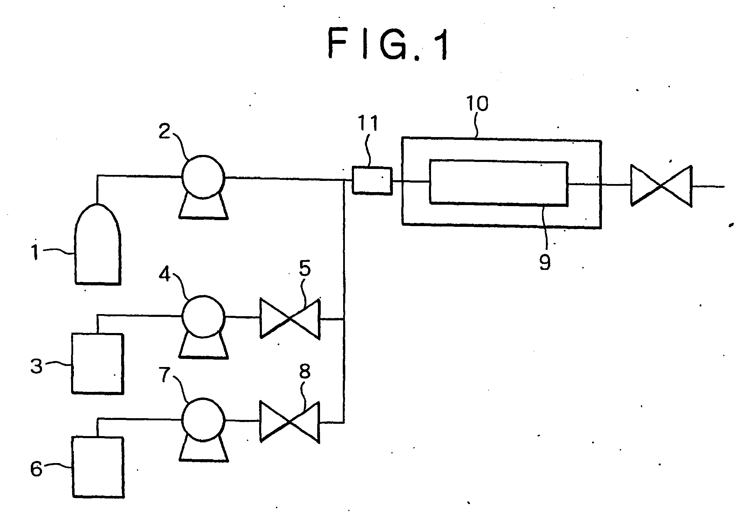

Figure 1 shows a simplified schematic drawing of an apparatus used for removing residues according to the present invention. Firstly, the semiconductor wafer having residues on its surface is introduced to and placed in a high pressure vessel 9, then CO₂ is supplied from a CO₂ cylinder 1 to the high pressure vessel 9 by a high pressure pump 2. The high pressure vessel 9 is thermostated at a specific temperature by a thermostat 10 in order to maintain the pressurized CO₂ in the high pressure vessel 9 at the supercritical condition. An additive and a co-solvent are supplied to the high pressure vessel 9 from tanks 3 and 6 by high pressure pumps 4 and 7, respectively, while the additive and co-solvent are mixed by a line mixer 11 on the way to the high pressure vessel 9. The flow rates of the additive and the co-solvent are adjusted by valves 5 and 8, respectively in order to set to the predetermined values. The CO₂, the additive and the co-solvent may be supplied continuously.

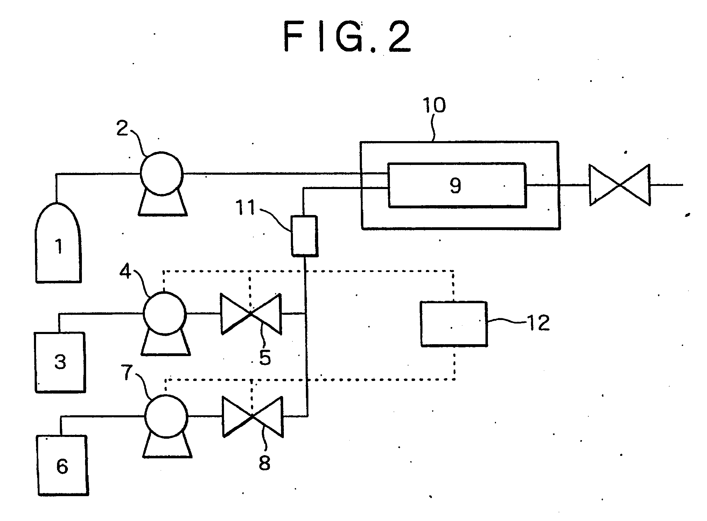

Figure 2 shows another embodiment of the apparatus for removing residues according to the present invention. In this apparatus, the additive is mixed with the co-solvent by the line mixer 11 before being fed into the high pressure vessel 9 in order to avoid heterogeneously contacting. The ratio of the additive and the co-solvent to be fed into the high pressure vessel 9 is controlled by a ratio controller 12, which regulates the feeding rate(s) of the additive and/or the co-solvent to the supercritical CO₂ in the high pressure vessel 9.

The removing process is performed at a temperature in the range from 31°C to 210°C, and at a pressure ranged from 5 M Pa to 30 M Pa, preferably, from 7.1 M Pa to 20 M Pa. The time required for removing the residues depends on the size of the object, the kind and amount of the residues, which is usually in the range from a minute to several ten minutes.

Hereinafter, the present invention is described with reference to experiments.

### EXPERIMENT 1

This experiment is carried out by dipping an object in an additive shown in table 1 at an atmospheric pressure at a temperature in the range of from 40°C to 100°C for 20 minutes. The object for this experiment is a silicon wafer having a SiO₂ layer coated with a novolac phenol type resist, patterned by a development, and treated to form microstructures on its surface by dry etching of a fluorine gas. A rate of removing residues is estimated as a ratio of an area of the surface adhering with residues after removing and before removing by a microscope. The term"×" and the term "O" mean that the rate is less than 90%, and 90% or more, respectively. The term "Ø" means the rate is 90% or more when the additive is diluted ten times by a co-solvent such as dimethylsulfoxide.

The results are summarized in table 1.

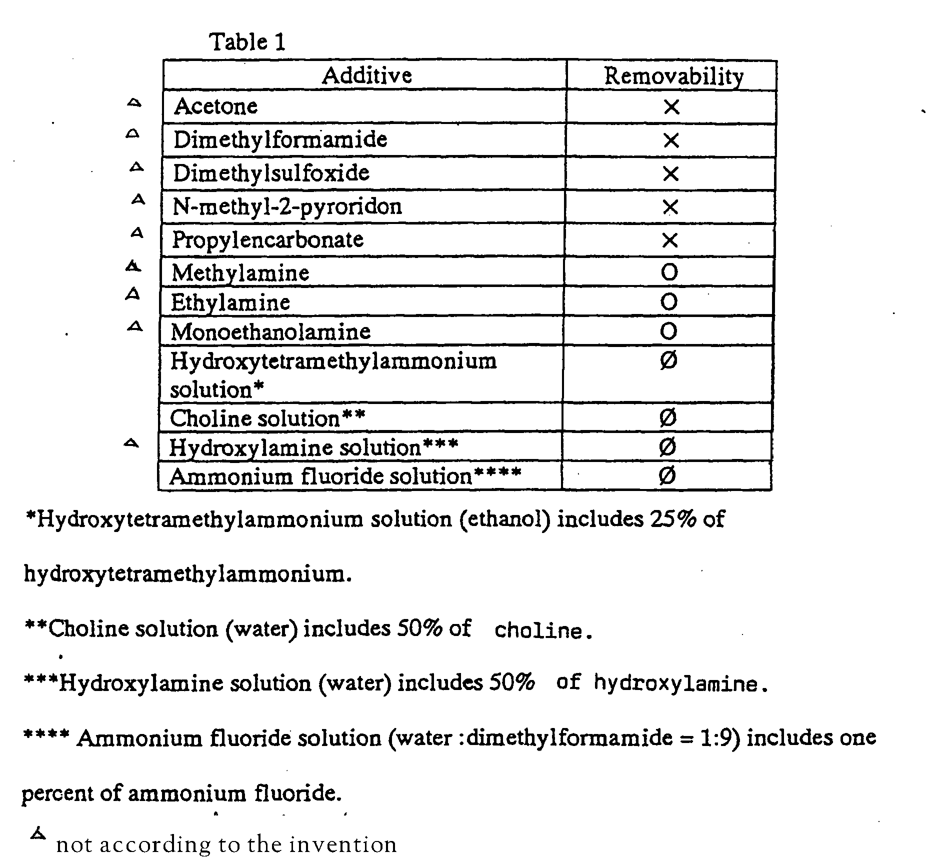

As shown in table 1, alkylamine (such as methylamine and ethylamine) , alkanolamine (such as monoethanolamine), quaternary ammonium hydroxide (such as TMAH and choline), hydroxylamine, and ammonium fluoride have high removability. Especially, quaternary ammonium hydroxide,hydroxylamine, and ammonium fluoride have a superior rate for removing residues.

### EXPERIMENT 2

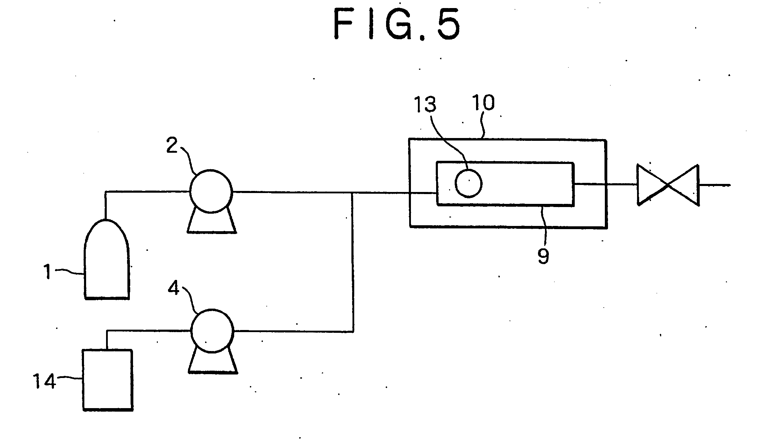

This experiment for investigating an effect of co-solvent on a solubility of additive in CO₂ is carried out via the apparatus shown in Fig. 5. CO₂ is introduced into the vessel 9 from the CO₂ cylinder 1 by the pump 2. The pressure and the temperature in the vessel are maintained at 20 MPa and 80°C by the thermostat 10. The additive and co-solvent are mixed in the ratio shown in table 2, then the mixture is introduced into the vessel 9 from the mixing tank 14 by the pump 4. The same amount of CO₂ as the mixture is evacuated from the vessel 9 so that the pressure is maintained at 20 MPa when the mixture is introduced. The effect of co-solvent, i.e., whether the additive is dissolved in CO₂, is observed through the glass window 13 of the vessel 9. When the additive is not dissolved in CO₂, two phases are observed through the window. The term " × " in table 2 means that the two phases are observed. The term "O" means the co-solvent makes the additive dissolved or dispersed homogeneously in CO₂ (the two phases are not observed).

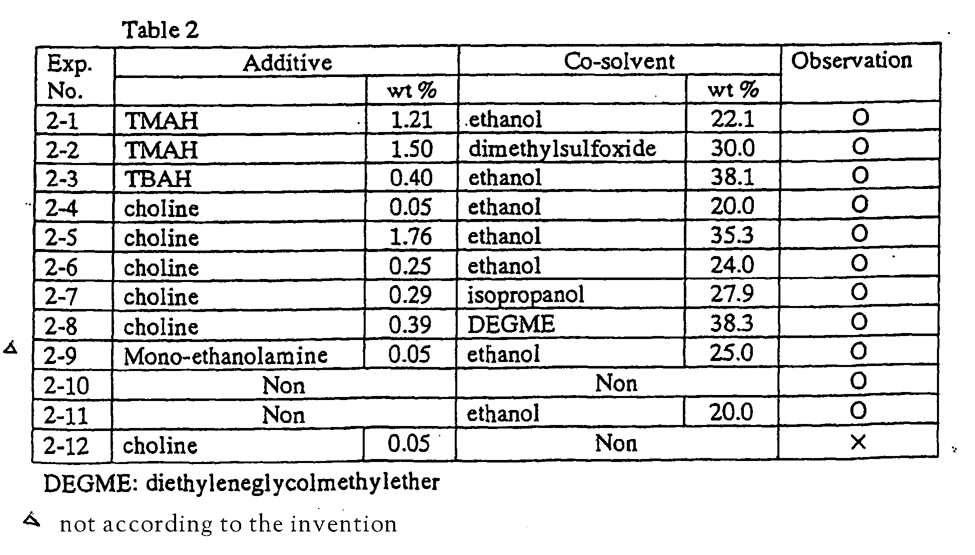

As shown in table 2, in experiment No. 2-1-2-9, the effects of co-solvents are confirmed. The conditions in experiment No. 2-1~2-9 observed through the window are transparent, homogenous, and without two phases.

### EXPERIMENT 3

This experiment for removing residues using a remover including high pressure CO₂, additive(s), and co-solvent(s) is carried out via the apparatus of Fig. 1. The object in this experiment is the same as the one in the experiment 1. The kind and concentration of the additive and co-solvent in the remover are shown in table 3. The terms "Ø", "O" and " X in table 3 indicate the rate of removing residues being 90% or more, 60% or more, and 10% or less, respectively.

**Table 3**

| Exp. No. | Additive | | Co-solvent | | Rate |
|---|---|---|---|---|---|
| | | Wt% | | Wt% | |
| 3-1 | Choline | 0.05 | Ethanol | 20.0 | O |
| 3-2 | Choline | 1.70 | Ethanol | 35.3 | Ø |
| 3-3 | TMAH | 1.21 | Methanol | 22.2 | Ø |
| 3-4 | TMAH | 1.50 | Dimethylsulfoxide | 30.0 | Ø |
| 3-5 | Non | | Non | | × |
| 3-6 | Non | | Ethanol | 20.0 | × |
| 3-7 | Non | | dimethylsulfoxide | 30.0 | × |

As shown in table 3, in the experiment No. 3-1-3-4, the residues are effectively removed.

### EXPERIMENT 4

This experiment for removing residues from the surface of semiconductor wafers is carried out by using a remover including additives H, I, G, J, L, and K which include the fluoride of formula NRIR2R3R4F (R represents a hydrogen or alkyl group). The compositions of the additives are listed in Table 4.

**Table 4 Compositions of Additive**

| Additive | Fluoride (wt % of additive) | Other components (wt % of additive) | |
|---|---|---|---|
| H | TMAF (13.43) | DMAC (62.5) | DIW (24.07) |
| I | TMAF (4.48) | DMAC (67.5) | DIW (28.02) |
| G | NH₄F (5.0) | DMAC (64.2) | DIW(12.4), AcOH (8.0), NH₄OAc (10.4) |
| J | TBAF (25) | DMAC (43) | Ethanol (32) |
| L | TBAF (32) | DMAC (39) | Ethanol (29) |
| K | TMAF (5) | DMAC (62.5) | Ethanol (32.5) |

| | | | |
|---|---|---|---|
| DMAC:Dimethylacetamide, DIW:De-ionized water, TMAF: Tetramethylammoniumfluoride, PG: Propyleneglycol, DMSO: Dimethylsulfoxide, AcOH: Acetic acid, TBAF: Tetrabutylammoniumfluoride, NH₄OAc: ammonium acetate. | | | |

In this experiment, three kinds of silicon wafers A, B and C are used. These silicon wafers have different patterns on their surfaces and the removing characteristics of their resists are also different. The silicon wafers are prepared to generate the thermal oxides of silicon on the surface thereof and broken into chips (1cm x 1cm). The chips are etched in the fluoride gas. Then the resists on the chips are ashed by a plasma to generate ashed resists. The chips are placed in the high pressure vessel 9. The solutions of additives H, I, G, J, K and L are prepared such that the fluoride is dissolved in the other components listed in the table 4, respectively. Then, such additives are introduced with CO₂ and ethanol into the high pressure vessel in Fig. 1. The temperature of CO₂ in the high pressure vessel 9 is 40°C, the pressure is 15 M Pa, and the time for making the chips contact with CO₂ is 3 minutes. After taken out from the high pressure vessel 9, the chips are observed with an electron microscope.

The result of this experiment is summarized in Table 5.

**Table 5**

| Run | Wafer | Additive | Conc. in Remover [wt%] | | Result |
|---|---|---|---|---|---|
| | | | Additive | Ethanol | |
| 1 | A | H | 0.05 | 5 | Excellent |
| 2 | A | I | 0.05 | 5 | Excellent |
| 3 | B | H | 0.05 | 5 | Fair |
| 4 | B | H | 0.10 | 5 | Excellent |
| 5 | B | H | 0.25 | 5 | Fair |
| 6 | B | I | 0.05 | 5 | Fair |
| 7 | C | H | 0.10 | 5 | Excellent |
| 8 | A | G | 0.05 | 5 | Fair, but water rinse needs to remove the residue newly appeared |
| 9 | A | J | 0.05 | 5 | Excellent |
| 10 | A | K | 0.05 | 5 | Excellent |
| 11 | A | L | 0.05 | | Excellent |
| 12 | B | J | 0.10 | 5 | Excellent |
| 13 | B | K | 0.10 | 5 | Excellent |
| 14 | B | L | 0.10 | 5 | Excellent |

The ashed resists on the wafer-A are cleaned by both 0.05wt% of H and I with 5wt% ethanol dissolved in the supercritical CO₂. The term "Excellent" means that there is no residues on the surface of the silicon wafer (chips). The term "Fair" means that there are a few residues on the surface or a little disappearance of the pattern. In Run 8 using NH₄F, a water rinse is needed to remove residue since a water-soluble residue newly appears on the surface of the silicon wafer (chips). In Runs 1 to 7 and 9 to 14, the water rinsing step subsequent to the removing step is not needed. In these cases, a solvent including CO₂ and alcohol, e.g. methanol and ethanol, but no water is preferably used for rinsing the silicon wafer. Further, in cases of the additives J, K and L, no water is substantially needed in both steps of removing and rinsing. Such method is superior because it uses substantially no water which becomes a hindrance for manufacturing semiconductor wafers.

Wafer-C contains more difficult ashed resists to be removed from the surface of the silicon wafer (chips). In order to remove this resist, longer removing time (three times longer than wafer-B) is required. The result is excellent.

### EXPERIMENT 5

The silicon wafers are prepared to generate the thermal oxides of silicon on their surface and are broken into chips. The chips are placed in the high pressure vessel 9 in Fig. 1. Then, a remover including CO₂, the additives, and ethanol is introduced into the high pressure vessel 9. After the removal treatment for several ten minutes, the chips are taken out and the thickness of the thermal oxides on the chips is measured by an ellipseometer. The etch rate of the thermal oxides is determined by dividing the decrease of the thickness per the treatment time. The temperature of CO₂ at the supercritical condition is 40C, the pressure is 15 M Pa, and the treatment time is 20 to 60 minutes.

The result of this experiment is summarized in Table 6

**Table 6**

| Additive | Concentration in Remover [wt%] | | Etch Rate of thermal oxides of silicon [A/min] |
|---|---|---|---|
| | additive | Ethanol | |
| H | 0.030 | 5.9 | 2.4 |
| H | 0.047 | 4.7 | 4.6 |
| H | 0.228 | 4.3 | 7.5 |
| I | 0.025 | 5.1 | 1.4 |
| I | 0.044 | 2.2 | 3.3 |
| I | 0.048 | 4.8 | 1.6 |
| I | 0.049 | 4.8 | 1.6 |
| I | 0.050 | 5.0 | 1.7 |
| I | 0.050 | 10.0 | 0.3 |
| I | 0.056 | 5.5 | 1.6 |
| I | 0.057 | 2.8 | 2.0 |
| I | 0.057 | 5.6 | 1.9 |
| I | 0.071 | 3.5 | 3.7 |
| I | 0.248 | 4.7 | 5.3 |
| G | 0.005 | 5.1 | 1.1 |
| G | 0.012 | 4.7 | -0.1 |
| G | 0.028 | 5.5 | 3.9 |
| G | 0.039 | 5.1 | 8.3 |
| G | 0.043 | 4.2 | 7.9 |
| G | 0.044 | 4.4 | 5.1 |

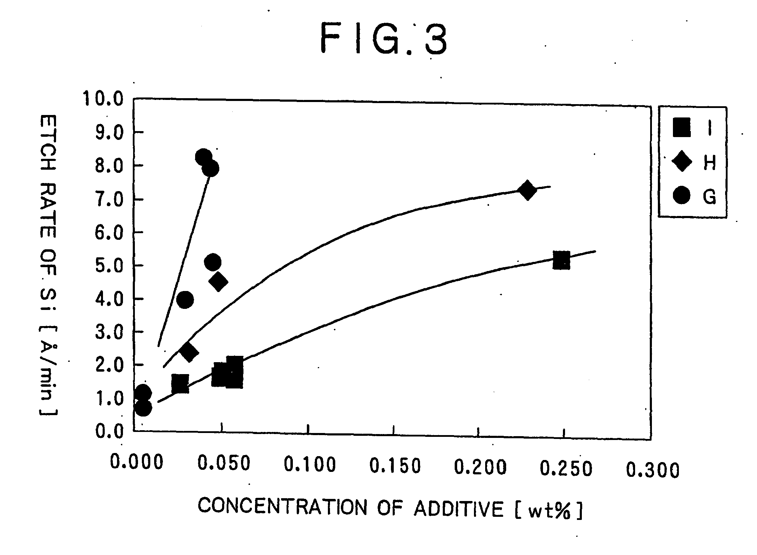

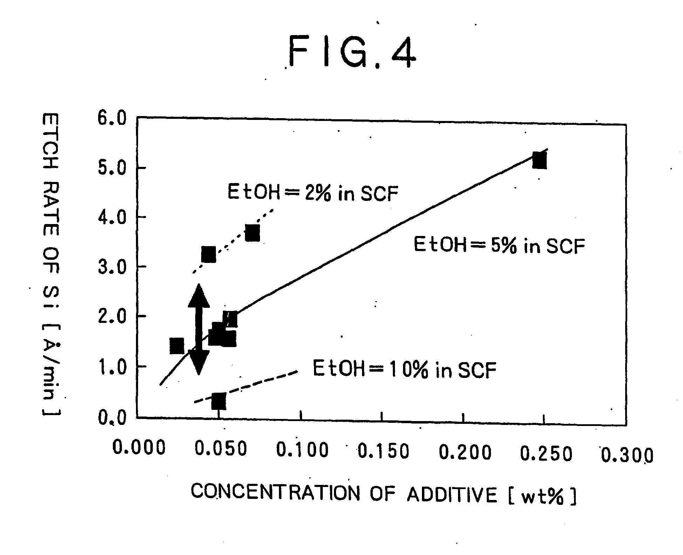

These data in table 6 are plotted in Figures 3 and 4. As shown in Figure 3, the etch rate of thermal oxides depends on the concentration of additives. Besides, as shown in Figure 4, if the concentration of the additive is constant, the etch rate varies according to the ethanol concentration. The etch rate can be controlled according to the removing objects or the removing process. As seen from Figures 3 and 4, the etch rate is controlled by adjusting the concentrations of the additive and ethanol, and their ratio.

## Claims

1. A process for removing residues from the microstructure of an object comprising steps of :
preparing a remover including CO₂, an additive for removing the residues and a
co-solvent for dissolving said additive in said CO₂ at a pressurized fluid condition; and
bringing the object into contact with said remover so as to remove the residues from the object,
wherein said additive includes a basic compound which is at least one element selected from the group consisting of quaternary ammoniumhydroxide and quaternary ammoniumfluoride.

2. The process according to claim 1 wherein said co-solvent is alcohol.

3. The process for removing residues from the microstructure of an object according to claim 1 or 2, further comprising the steps of:
placing the object inside a vessel, wherein the vessel is provided with at least one inlet for feeding CO₂ into said vessel, an additive for removing the residues, and a co-solvent for dissolving the additive in the CO₂;
pressurizing the CO₂ to be fed into said vessel; and
heating the pressurized CO₂ in said vessel so as to maintain the pressurized CO₂ at a predetermined temperature.

4. The process according to claim 3, further comprising the step of:
mixing the additive and the co-solvent before being fed into said vessel.

5. The process according to claim 3 or 4, further comprising the step of:
providing a controller for adjusting a feed rate of at least one of the additive and the co-solvent to be fed into said vessel.

6. The process according to anyone of claims 3 to 5, further comprising the step of:
providing a thermostat for said vessel for keeping the pressurized CO₂ in said vessel at the predetermined temperature.

7. A process for removing residues from the microstructure of an object comprising a step of :
contacting the object with a remover including a supercritical CO₂, a compound having a hydroxyl group, and a fluoride of formula NR1R2R3R4F,
where R represents a hydrogen or alkyl group.

8. The process according to claim 7, wherein saidRs are alkyl groups.

9. The process according to claim 7 or 8, wherein said fluoride is a tetramethylammoniumfluoride and said compound is an alcohol.

10. The process according to anyone of claims 7 to 9, wherein said remover includes substantially no water.

11. The process according to anyone of claims 7 to 10, further comprising a step of rinsing the object by using a solvent including substantially no water.

12. A process for removing residues from the microstructure of an object comprising steps of :
placing the object in a vessel;
feeding into the vessel CO₂, a compound having a hydroxyl group, and a fluoride of formula NR1R2R3R4F, where R represents a hydrogen or alkyl group; and
maintaining said CO₂ including said fluoride and said compound at a supercritical condition to contact the object with said CO₂, wherein a concentration of at least one of said fluoride and said compound in said CO₂ is so adjusted as to control an etch rate of etching the object so as to remove the residues.

13. A process for removing residues from a semiconductor wafer comprising steps of:
ashing a resist on a surface of the semiconductor wafer; and
contacting the semiconductor wafer with supercritical CO₂ including a compound having a hydroxyl group and a fluoride of formula NR1R2R3R4F,
where R represents a hydrogen or alkyl group, so as to remove ashed resist from the semiconductor wafer.

## Patentansprüche

1. Verfahren zum Entfernen von Rückständen von der Mikrostruktur eines Objektes, welches die Schritte umfasst:
das Herstellen eines Entferners, welcher CO₂, ein Additiv zum Entfernen der Rückstände und ein Hilfslösungsmittel zum Lösen des Additivs in dem CO₂ unter der Bedingung eines unter inneren Überdruck gesetzten Fluids einschließt, und
das Inkontaktbringen des Objektes mit dem Entferner, um die Rückstände von dem Objekt zu entfernen,
wobei das Additiv eine basische Verbindung einschließt, welche mindestens ein Element, ausgewählt aus der Gruppe, bestehend aus quartärem Ammoniumhydroxid und quartärem Ammoniumfluorid, ist.

2. Verfahren nach Anspruch 1, wobei das Hilfslösungsmittel Alkohol ist.

3. Verfahren zum Entfernen von Rückständen von der Mikrostruktur eines Objektes nach Anspruch 1 oder 2, welches weiter die Schritte umfasst:
das Anordnen des Objektes in ein Gefäß, wobei das Gefäß mit mindestens einem Einlass zum Einspeisen von CO₂ in das Gefäß, einem Additiv zum Entfernen der Rückstände und einem Hilfslösungsmittel zum Lösen des Additivs in dem CO₂ ausgestattet ist,
das Setzen des in das Gefäß einzuspeisende CO₂ unter inneren Überdruck, und
das Erwärmen des unter inneren Überdruck gesetzten CO₂ in dem Gefäß, um das unter inneren Überdruck gesetzte CO₂ bei einer vorbestimmten Temperatur zu halten.

4. Verfahren nach Anspruch 3, welches weiter den Schritt umfasst:
das Mischen des Additivs und des Hilfslösungsmittels vor dem Einspeisen in das Gefäß.

5. Verfahren nach Anspruch 3 oder 4, welches weiter den Schritt umfasst:
das Bereitstellen einer Kontrolleinheit zum Einstellen einer Beschickungsgeschwindigkeit des in das Gefäß einzuspeisenden mindestens einen von dem Additiv und dem Hilfslösungsmittel.

6. Verfahren nach einem der Ansprüche 3 bis 5, welches weiter den Schritt umfasst:
das Bereitstellen eines Thermostates für das Gefäß zum Halten des unter inneren Überdruck gesetzten CO₂ in dem Gefäß bei der vorbestimmten Temperatur.

7. Verfahren zum Entfernen von Rückständen von der Mikrostruktur eines Objektes, welches den Schritt umfasst:
das Inkontaktbringen des Objektes mit einem Entferner, welcher superkritisches CO₂, eine Verbindung mit einer Hydroxylgruppe und ein Fluorid der Formel NR1 R2R3R4F einschließt, wobei R ein Wasserstoff oder eine Alkylgruppe darstellt.

8. Verfahren nach Anspruch 7, wobei die Rs Alkylgruppen sind.

9. Verfahren nach Anspruch 7 oder 8, wobei das Fluorid ein Tetramethylammoniumfluorid ist und die Verbindung ein Alkohol ist.

10. Verfahren nach einem der Ansprüche 7 bis 9, wobei der Entferner im Wesentlichen kein Wasser einschließt.

11. Verfahren nach einem der Ansprüche 7 bis 10, welches ferner einen Schritt des Spülens des Objektes durch Verwendung eines Lösungsmittels, welches im Wesentlichen kein Wasser einschließt, umfasst.

12. Verfahren zum Entfernen von Rückständen von der Mikrostruktur eines Objektes, welches die Schritte umfasst:
das Anordnen des Objektes in einem Gefäß,
das Einspeisen von CO₂, einer Verbindung mit einer Hydroxylgruppe und eines Fluorids der Formel NR1 R2R3R4F in das Gefäß, wobei R ein Wasserstoff oder eine Alkylgruppe darstellt, und
das Halten des CO₂, welches das Fluorid und die Verbindung einschließt, unter einer superkritischen Bedingung, um das Objekt mit dem CO₂ in Kontakt zu bringen, wobei eine Konzentration mindestens eines des Fluorids und der Verbindung in dem CO₂ derart eingestellt wird, eine Ätzgeschwindigkeit des Ätzens des Objektes zu kontrollieren, um die Rückstände zu entfernen.

13. Verfahren zum Entfernen von Rückständen von einem Halbleiterwafer, welches die Schritte umfasst:
das Veraschen eines Resists auf einer Oberfläche des Halbleiterwafers, und
das Inkontaktbringen des Halbleiterwafers mit superkritischem CO₂, welches eine Verbindung mit einer Hydroxylgruppe und ein Fluorid der Formel NR1 R2R3R4F einschließt, wobei R ein Wasserstoff oder eine Alkylgruppe darstellt, um den veraschten Resist von dem Halbleiterwafer zu entfernen.

## Revendications

1. Procédé de décapage des résidus de la microstructure d'un objet comprenant les étapes de :
Préparation d'un décapant comprenant du CO₂, un additif pour enlever les résidus et un co-solvant pour dissoudre ledit additif dans ledit CO₂ dans une condition de fluide pressurisé ; et
Porter l'objet en contact avec ledit décapant de façon à enlever les résidus de l'objet,
Dans lequel ledit additif comprend un composé de base qui est au moins un élément choisi dans le groupe consistant en hydroxyde d'ammonium quaternaire et en fluorure d'ammonium quaternaire.

2. Procédé selon la revendication 1, dans lequel ledit co-solvant est un alcool

3. Procédé pour enlever les résidus de la microstructure d'un objet selon la revendication 1 ou 2, comprenant en outre les phases consistant à :
Placer l'objet à l'intérieur d'un récipient, dans lequel le récipient est doté d'au moins une entrée pour amener du CO₂ dans ledit récipient, un additif pour enlever les résidus, et un co-solvant pour dissoudre l'additif dans le CO₂ ;
Pressuriser le CO₂ à amener dans ledit récipient ; et
Chauffer le CO₂ pressurisé dans ledit récipient de façon à maintenir le CO₂ pressurisé à une température prédéterminée.

4. Procédé selon la revendication 3, comprenant en outre la phase consistant à
Mélanger l'additif et le co-solvant avant qu'ils ne soient amenés à l'intérieur dudit récipient.

5. Procédé selon la revendication 3 ou 4, comprenant en outre la phase consistant à :
Fournir un contrôleur pour ajuster une vitesse d'alimentation d'au moins un élément parmi l'additif et le co-solvant à amener dans ledit récipient.

6. Procédé selon l'une quelconque des revendications 3 à 5, comprenant en outre la phase consistant à :
Prévoir un thermostat pour ledit récipient afin de maintenir le CO₂ pressurisé dans ledit récipient à la température prédéterminée.

7. Procédé pour enlever des résidus de la microstructure d'un objet comprenant l'étape consistant à :
faire entrer en contact l'objet avec un décapant comprenant du CO₂ surcritique, un composé ayant un groupe hydroxyle, et un fluorure de la formule NR1R2R3R4F, où R représente un hydrogène ou un groupe alkyle.

8. Procédé selon la revendication 7, dans lequel lesdits R sont des groupes alkyles.

9. Procédé selon la revendication 7 ou 8, dans lequel ledit fluorure est un fluorure de tétraméthylammonium et ledit composé est un alcool.

10. Procédé selon l'une quelconque des revendications 7 à 9, dans lequel ledit décapant ne comprend pratiquement pas d'eau.

11. Procédé selon l'une quelconque des revendications 7 à 10, comprenant en outre une phase consistant à rincer l'objet, en utilisant un solvant ne comprenant pratiquement pas d'eau.

12. Procédé pour enlever des résidus de la microstructure d'un objet comprenant les phases consistant à Placer l'objet dans un récipient :
Amener dans le récipient du CO₂, un composé ayant un groupe hydroxyle et un fluorure de la formule NR1R2R3R4F, où R représente un hydrogène ou un groupe alkyle ; et
Maintenir ledit CO₂ comprenant ledit fluorure et ledit composé dans une condition surcritique, afin de faire entrer en contact l'objet avec ledit CO₂, dans lequel une concentration d'au moins un entre ledit fluorure et ledit composé dans ledit CO₂ est ajustée, de façon à contrôler un taux de décapage de l'objet de façon à enlever les résidus.

13. Procédé pour enlever les résidus d'une rondelle de semi-conducteur comprenant des étapes consistant à :
Réduire en cendres une réserve sur une surface de la rondelle de semi-conducteur; et
Faire entrer en contact la rondelle de semi-conducteur avec du CO₂ surcritique comprenant un composé ayant un groupe hydroxyle et un fluorure de formule NR1R2R3R4F, où R représente un groupe hydrogène ou alkyle, de façon à enlever une réserve de cendre à partir de la rondelle de semi-conducteur.
